# EUROPEAN PATENT APPLICATION

(11) **EP 2 608 272 A1**
(43) Date of publication of application: **26.06.2013**
(21) Application number: 11195724.7
(22) Date of filing: 23.12.2011
(51) Int. Cl.: H01L 29/78, H01L 29/74, H01L 29/749, H01L 29/49

(54) **N-channel LDMOS device**

(71) Applicant: IMEC, 3001 Leuven (BE); Katholieke Universiteit Leuven, 3000 Leuven (BE)
(72) Inventor: Chen, Shih-Hung, 3000 Leuven (BE); Griffoni, Allessio, 30030 Fossò Venice (IT); Thijs, Steven, 2830 Willebroek (BE); Linten, Dimitri, 3190 Boortmeerbeek (BE)
(74) Representative: Sarlet, Steven Renaat Irène

(57) **Abstract**

The disclosure relates to an n-channel LDMOS device comprising an n+ source (11) in a p-well region (12) and an n+ drain (21) in an n-well region (22), a channel (14) extending in the p-well region (12) between the n+ source (11) and the n-well region (22) in operation, and a poly gate (3) having a first part (31) above the channel and spanning the entire channel and a second part (32) extending above a part (24) of the n-well region (22) for forming a gate-to-n-well-overlap. The poly gate (3) is a hybrid n+/p+ structure wherein the first part (31) is an n+ part and the second part (32) is a p+ part.

## Description

### Technical field

The present disclosure relates to an n-channel laterally diffused metal-oxide-semiconductor (nLDMOS) device according to the preamble of the first claim.

### Background art

The integration of high-voltage (HV) and power components into standard logic complementary metal-oxide-semiconductor (CMOS) is one of the most important means of developing cost-effective system-on-a-chip solutions in the field of integrated CMOS-microelectromechanical systems (MEMS), line drivers, universal serial bus interfaces, nonvolatile memory devices, display and light-emitting-diode drivers, 3-D stacked integrated circuits (ICs), automotive, etc.

The HV-tolerant circuit design should be allowed to span the entire design space that the logic design enjoys. However, CMOS technology scaling imposes the reduction of power supply voltage to reduce power consumption and meet the reliability of ultrathin gate oxides (GOXs). As a consequence, reliability constraints such as electrostatic discharges (ESD), electrical overstress across a GOX, and hot-carrier degradation in input/output design can take away the flexibility to cover a broad range of operating voltages. This incompability between a technology developed for low-voltage operation and the manufacture of devices in this technology which must be able to withstand higher voltages can be problematic.

The ESD protection of these HV-tolerant devices is very critical. One technique to improve ESD robustness is embedding an additional diffusion region that forms a parasitic silicon-controlled rectifier (SCR) structure with reversible snapback capabilities. This latter device, which is also known as an n-channel LDMOS (nLDMOS)-SCR, is one of the most robust ESD protections since it has excellent clamping capabilities and ESD area performance.

In A. Griffioni et. Al., "OFF-State Degradation of High-Voltage-Tolerant nLDMOS-SCR ESD Devices", IEEE Transactions On Electron Devices, Vol. 58, No. 7, July 2011, pp. 2061-6071, the OFF-state reliability of HV tolerant nLDMOS-SCR devices is investigated. It was found that the devices suffer from impact ionization induced by electron-conduction-band tunneling from the n+ poly-Si gate to the n-well, which causes degradation of the OFF-state drain current.

### Disclosure

It is an aim of the present disclosure to provide an nLDMOS device with improved properties in which OFF-state leakage current from the poly gate to the drain is suppressed.

This aim is achieved according to the disclosure with the nLDMOS device showing the technical characteristics of the first claim.

According to the disclosure, the standard n+ poly gate of prior art nLDMOS devices is replaced by a hybrid n+/p+ poly gate having an n+ part above and extending across the entire channel and a p+ part above the n-well region.

As a result of the presence of the p+ part, an nLDMOS device with improved properties can be achieved. As will be shown herein, the hybrid n+/p+ poly gate can lead to a suppression of gate leakage currents, enhanced ESD protection and/or enhanced long-term reliability (in high voltage tolerant applications).

An advantage is that the structure according to the disclosure is fully compatible with standard CMOS processes, as the structure is similar to a gated diode structure.

### Brief description of the drawings

The disclosure will be further elucidated by means of the following description and the appended figures.
Figure 1 shows a cross-sectional view of an nLDMOS SCR device with hybrid poly gate according to an embodiment of the disclosure.
Figure 2 shows measurement results for the gate leakage current under a DC stress experiment for a prior art device.
Figure 3 shows energy band diagrams of the n+ and p+ poly gates/oxide/n-well.
Figure 4 shows comparative simulation results for the gate leakage current in nLDMOS SCR devices with n+ poly and p+ poly gate above n-well region.
Figures 5 and 6 show comparative simulation results for Id-Vd charasteristics and OFF-state gate leakage current.

### Modes for carrying out the disclosure

The present disclosure will be described with respect to particular embodiments and with reference to certain drawings but the disclosure is not limited thereto but only by the claims. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the disclosure.

Furthermore, the terms first, second, third and the like in the description and in the claims, are used for distinguishing between similar elements and not necessarily for describing a sequential or chronological order. The terms are interchangeable under appropriate circumstances and the embodiments of the disclosure can operate in other sequences than described or illustrated herein.

Moreover, the terms top, bottom, over, under and the like in the description and the claims are used for descriptive purposes and not necessarily for describing relative positions. The terms so used are interchangeable under appropriate circumstances and the embodiments of the disclosure described herein can operate in other orientations than described or illustrated herein.

The term "comprising", used in the claims, should not be interpreted as being restricted to the means listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present disclosure, the only relevant components of the device are A and B.

Nowadays, some applications, such as mixed signal, power and RF functions, are typically realized as stand-alone chips in a mature technology node. The final consumer products are implemented in a System-in-Package (SiP) architecture by assembling several chips in order to achieve a spacey and costly solution. Moreover, to truly benefit from the digital technology advances with the low CMOS cost per area and to further continue portable application miniaturization, these discrete chips are embedded in the multiple functionalities on a single chip using the most advanced digital technology. However, such application implies that the transistors with 1.2 V (or even less) technologies must be able to receive or transmit (to be operated at or sustain) external signal levels up to 3.3 V or 5 V.

The transistors on these transceiving signal paths should thus be able to sustain a higher voltage potential operation, and the corresponding input/output pins also should have dedicated high voltage tolerant ESD protection elements connected to avoid the ESD threats to them. One of the suitable choices is an nLDMOS SCR protection structure. However, prior art devices of this type can be very sensitive to gate leakage and gate oxide degradation in long-term reliability.

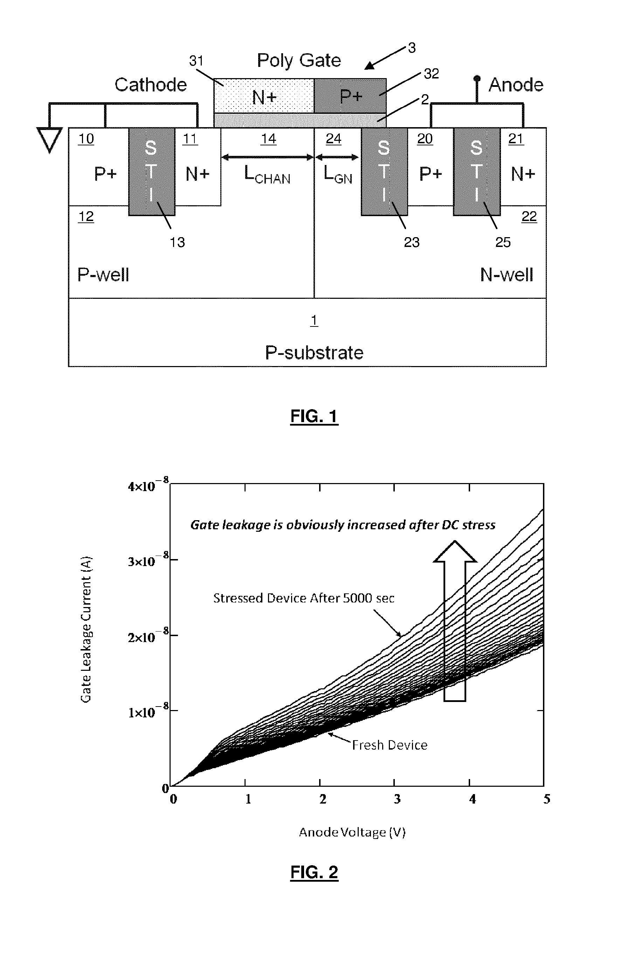

Figure 1 shows a preferred embodiment of an n-channel laterally diffused metal-oxide-semiconductor (nLDMOS) device according to the disclosure, more particularly a silicon controller rectifier (SCR) device. The SCR comprises a p-substrate 1 with:
- an n+ source 11 in a p-well region 12;
- an n+ drain 21 in an n-well region 22;
- an n-channel 14 extending between the n+ source 11 and the n-well region 22;
- a first p+ region 10 in the p-well region 12 on a side of the n+ source 11 opposite the n-channel 14 and laterally isolated from the n+source 11 by a shallow trench isolation (STI) region 13;
- a second p+ region 20 in the n-well region 22 in between the n+ drain 21 and the channel 14, more particularly between the n+ drain 21 and a surface part 24 of the n-well region 22 adjacent to the channel 14, and laterally isolated from the surface part 24 and the n+ drain 21 by STI regions 23, 25;
- a poly gate 3 having a first part 31 above the channel 14 and spanning the entire channel 31 and a second part 32 extending above the n-well region 22 for forming a gate-to-n-well-overlap above the surface part 24 of the n-well region 22.

The poly gate 3 is a hybrid n+/p+ structure wherein the first part is an n+ part 31 and the second part is a p+ part 32. It is isolated from the channel 14 and the surface part 24 by a gate oxide 2, of which the thickness is predefined by the processing (e.g. sub 100 nm CMOS).

The surface part 24 of the n-well region 22 has a length, known in the art as the gate-to-n-well overlap length L_{GN} of 0.1 to 1.0 µm, preferably 0.25 µm. The channel length L_{CHAN} is preferably larger than the L_{GN}.

It is remarked that in reality there is no distinct separation between the regions, as they are defined by doping concentrations which vary gradually in the substrate. For example, the separation line drawn between the p-well and the n-well refers to the fact that on one side (the left hand side on the figure) the p-type doping concentration is higher than the n-type doping concentration and on the other side (the right hand side on the figure) the n-type doping concentration is higher than the p-type doping concentration. This is known in the art and therefore needs no further explanation here. The doping concentrations used in the devices according to the disclosure are standard doping concentrations for CMOS processing (with "+" referring to a higher level doping concentration relative to other regions in the device), so this also needs no further explanation here.

Though fig. 1 shows the disclosure implemented in an nLDMOS SCR structure, this is not the only application. The disclosure is more generally applicable in any nLDMOS structure, with one or more of the following advantageous effects: suppression of gate leakage currents, enhanced ESD protection (when used for ESD protection) due to suppression of the gate tunnelling current and/or enhanced long-term reliability (in high voltage tolerant applications).

For example, figure 2 shows how the gate oxide degrades in a prior art nLDMOS SCR with n+ poly gate above the n-well region. This is shown by means of a DC stress experiment: the gate leakage current increases over time. This degradation can be tackled by implementing the hybrid gate according to the disclosure.

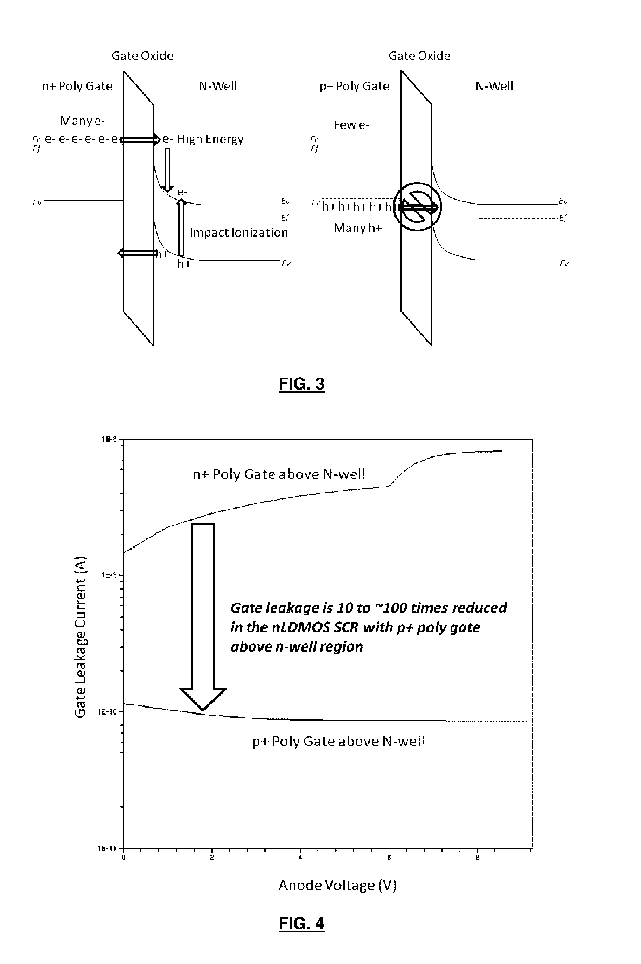

Figure 3 explains by means of energy band diagrams why this advantageous effect(s) can be achieved, comparing the prior art device (on the left) with an nLDMOS device according to the disclosure (on the right). The prior art device suffers from large gate leakage and oxide degradation. The device according to the disclosure has fewer electrons in the p+ part 32 of the poly gate 3 and hence less electron tunnelling, and furthermore the n-well 22 is at high potential so fewer holes and hence less hole tunnelling from gate 32 to n-well 22.

Figure 4 shows simulation results to compare the prior art device having an n+ poly gate with a device having a pn poly gate according to Fig. 1. The graph shows that the gate leakage is 10 to 100 times reduced in the nLDMOS SCR with p+ poly gate above the n-well region.

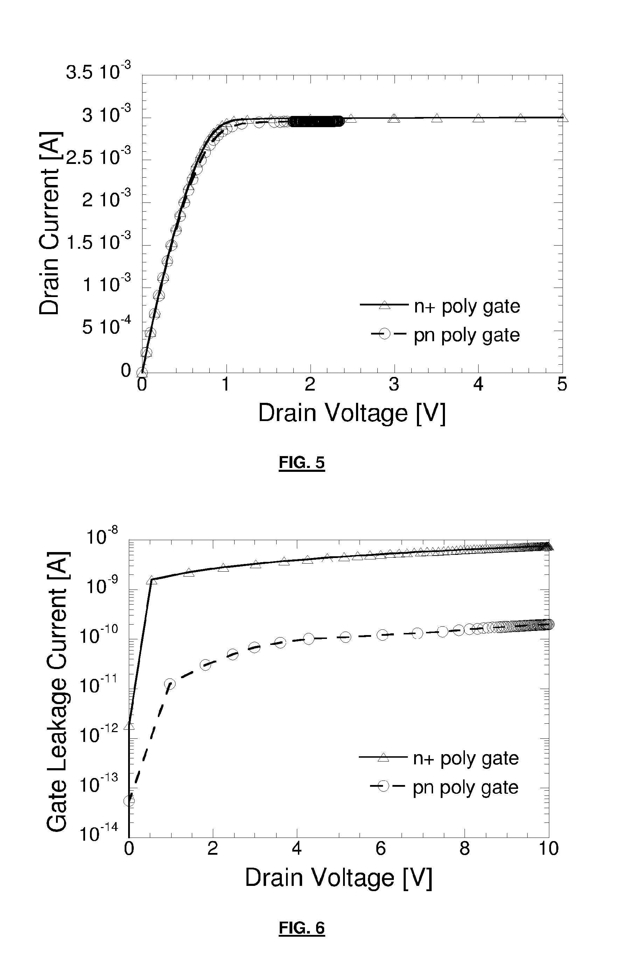

Figure 5 shows simulated Id-Vd charasteristics to compare the prior art device with a device according to Fig. 1. The following bias conditions are simulated:
- Gate: 1.32 V
- Drain: sweep
- Source & Bulk: 0

The resulting Id-Vd characteristics show that 98.6 % of the drain driving current of the prior art device can be reached with the device having the hybrid poly gate. Hence device configuration for improving the leakage behaviour has no substantial impact on the device performance.

Figure 6 shows simulated OFF-state gate leakage current to compare the prior art device with a device according to Fig. 1. The following bias conditions are simulated:
- Gate: 0 V
- Drain: sweep
- Source & Bulk: 0 V

The results show that the gate leakage current in the case of the hybrid poly gate is only 2.6 % of the gate leakage current with the prior art device.

## Claims

1. n-channel laterally diffused metal-oxide-semiconductor device comprising an n+ source (11) in a p-well region (12) and an n+ drain (21) in an n-well region (22), an n-channel (14) extending between the n+ source (11) and the n-well region (22), and a poly gate (3) having a first part (31) above the channel and spanning the entire channel (14) and a second part (32) extending above a part (24) of the n-well region (22) for forming a gate-to-n-well-overlap, **characterised in that** the poly gate (3) is a hybrid n+/p+ structure wherein the first part (31) is an n+ part and the second part (32) is a p+ part.

2. n-channel laterally diffused metal-oxide-semiconductor device according to claim 1, wherein the device is a silicon-controlled-rectifier structure further comprising a first p+ region (10) in the p-well region (12) on a side of the n+ source (11) opposite the n-channel (14) and laterally isolated from the n+ source (11) by an isolation region (13); and a second p+ region (20) in the n-well region (22) in between the n+ drain (21) and said part (24) and laterally isolated therefrom by isolation regions (23, 25).

3. n-channel laterally diffused metal-oxide-semiconductor device according to claim 1 or 2, wherein said part (24) of the n-well region (22) has a gate-to-n-well overlap length (L_{GN}) of 0.1 to 1.0 µm, preferably 0.25 µm.

4. A CMOS circuit comprising an ESD protection device comprising the n-channel laterally diffused metal-oxide-semiconductor device according to any one of the previous claims.

5. A low-voltage CMOS circuit comprising a high-voltage tolerant n-channel laterally diffused metal-oxide-semiconductor device according to any one of the claims 1-3.

6. A system-in-package comprising the CMOS circuit according to claim 5.
